# EUROPEAN PATENT APPLICATION

(11) **EP 1 898 459 A2**
(43) Date of publication of application: **12.03.2008**
(21) Application number: 07116022.0
(22) Date of filing: 10.09.2007
(51) Int. Cl.: H01L 21/78

(54) **Wafer processing method and wafer processing apparatus**

(30) Priority: 11.09.2006 JP 2006245645
(71) Applicant: TOKYO SEIMITSU CO., LTD., Mitaka-shi Tokyo (JP)
(72) Inventor: Hayashi, Tomoo c/o Tokyo Seimitsu Co., Ltd., Tokyo (JP)
(74) Representative: Skone James, Robert Edmund

(57) **Abstract**

A wafer processing apparatus (10) has a grinder (80) for grinding the back surface (22) of a wafer (20) on whose front surface (21) a circuit pattern (C) has been formed, and a die attachment paste applicator (30) for applying die attachment paste on the entire back surface of the wafer ground by the grinder. With this arrangement, die attachment paste can be applied to a wafer in a short period of time without using a film. The die attachment paste applicator is either a spin-coater (30A) that spin-coats die attachment paste supplied on the back surface of a wafer, or a screen-printing device (30B) that screen-prints die attachment paste on the back surface of a wafer.

## Description

### BACKGROUND OF THE INVENTION

### 1. Field of the Invention

The present invention relates to a wafer processing method for applying a die attachment paste to the back surface of a wafer, and a wafer processing apparatus for executing such a method.

### 2. Description of the Related Art

In a semiconductor manufacturing process, a wafer on the front surface of which a predefined circuit pattern has been formed is diced and made into chips. Each IC chip obtained from the process is die-bonded onto a metal lead frame, tape substrate, or an organic hard substrate, etc., and built into a semiconductor device.

Under Japanese Unexamined Patent Publication (Kokai) No. 2005-294535, when such IC chips are die-bonded, a die attachment film is stuck on the chip surface (the back surface) whereon a circuit pattern has not been formed. The die attachment film is an adhesive in a film form. After the wafer is divided into pieces by dicing, the IC chips are picked up. The IC chips are die-bonded to a metal lead frame or the like with the die attachment film that was applied to the back surfaces and serving as an adhesive.

Wafers are becoming larger and larger, year by year in semiconductor manufacturing, and at the same time there is a trend toward making wafers increasingly thinner with a view to increasing packaging density. Today, thin wafers are obtained by grinding of their back surfaces. Then, it is desirable that the die attachment film placed between the IC chips formed as a result of dicing and the lead frame or the like be made thin to further reduce the thickness of the chips.

However, there are technical limits to making die attachment film thin. Furthermore, the thinner the die attachment film is made, the more difficult it is to handle. Therefore, there is a possibility that a semiconductor manufacturing process may become more complicated as a result of die attachment film being made thin.

Presently, a die attachment paste made of an adhesive paste is being applied instead of a die attachment film. However, as die attachment paste is supplied to the board by means of screen-printing or the like, and IC chips are mounted and stuck on top of the paste, it is necessary to supply the die attachment paste by screen-printing or the like to each board and the semiconductor manufacturing process becomes more complicated in such a case.

The present invention was conceived in view of the above problem and its objective is to provide a wafer processing method that makes it possible to apply a die attachment paste in a relatively period of short time without using a die attachment film, and a wafer processing apparatus for executing such a method.

### SUMMARY OF THE INVENTION

To realize the abovementioned objective, according to a first aspect of the invention, a wafer processing method comprises a grinding step for grinding a back surface of a wafer having on its front surface a circuit pattern, and a die attachment paste application step for applying a die attachment paste to the entirety of the ground back surface of the wafer.

In order words, in the first aspect, the die attachment paste is applied in one operation to the entirety of the ground back surface of the wafer. Therefore, the die attachment paste can be applied in a relatively short period of time without using a die attachment film.

In a second aspect, the wafer processing method, as defined by the first aspect, further comprises the steps of sticking a dicing tape to the applied die attachment paste, dicing the wafer according to the circuit pattern.

In other words, in the second aspect, the wafer is divided into individual chips, which can be mounted on a lead frame or the like.

In a third aspect, as defined by the first or second aspect, the die attachment paste supplied to the back surface of the wafer in the die attachment paste application step in the first or second embodiment is spin-coated.

In other words, in the third aspect, the die attachment paste can be applied at the required thickness, even in cases where the thickness of die attachment paste required is quite thin.

In a fourth aspect, as defined by the first or second aspect, the die attachment paste is screen-printed on the back surface of the wafer in the die attachment paste application step as in the first or second aspect.

In other words, in the fourth aspect, the die attachment paste can be applied to the back surface of the wafer relatively easily and quickly.

In a fifth aspect, as defined by the fourth aspect, the die attachment paste is applied except in the portions corresponding to channels formed when the wafer is diced in the screen-printing step.

In other words, in the fifth aspect, it is possible, when the wafer is diced using dicing blades, to prevent the dicing blades from becoming clogged with the die attachment paste, and their cutting capability from being reduced. Moreover, laser dicing can also be used since there is no need to cut the die attachment paste layer before or after the dicing.

According to a sixth aspect, a wafer processing apparatus comprises a grinding means for grinding the back surface of the wafer having on its front surface a circuit pattern, and a die attachment paste application means for applying a die attachment paste on the entire back surface of the wafer ground by the grinding means.

In other words, in the sixth aspect, the die attachment paste is applied in one operation to the entirety of the ground back surface of the wafer. Therefore, a die attachment paste can be applied in a relatively short period of time without using a die attachment film.

In a seventh aspect, the wafer processing apparatus, as defined by the sixth aspect, comprises a dicing tape sticking means for sticking a dicing tape to the die attachment paste applied by the die attachment paste application means, and a dicing means for dicing the wafer according to the circuit pattern, in addition to the means provided in the sixth aspect.

In other words, in the seventh aspect, the wafer is divided into individual chips that can be mounted on a lead frame or the like.

In an eighth aspect, as defined by the sixth or seventh aspect, the die attachment paste application means in the sixth or seventh embodiment comprises a spin-coating means for spin-coating the die attachment paste supplied to the back surface of the wafer.

In other words, in the eighth aspect, the die attachment paste can be applied at the required thickness, even in cases where the thickness of die attachment paste required is quite thin.

In a ninth aspect, as defined by the sixth or seventh aspect, the die attachment paste application means in the sixth or seventh embodiment comprises a screen-printing means for screen-printing the die attachment paste to the back surface of the wafer.

In other words, in the ninth aspect, the die attachment paste can be applied to the back surface of the wafer relatively easily and quickly.

In a tenth aspect, as defined by the ninth aspect, the screen-printing means in the ninth embodiment applies the die attachment paste except on the portions corresponding to the channels formed when the wafer is diced.

In other words, in the tenth aspect, it is possible, when the wafer is diced using dicing blades, to prevent the dicing blades from becoming clogged with the die attachment paste, and their cutting capability from being reduced. Moreover, laser dicing can also be used since there is no need to cut the die attachment paste layer before or after the dicing.

The detailed explanation of the typical embodiments of the present invention, which are shown in the attached drawings, will surely serve to make clearer the abovementioned and other objectives, characteristics and benefits of the present invention.

### BRIEF DESCRIPTION OF THE DRAWINGS

Figure 1 is a schematic plan view of a wafer processing apparatus according to the present invention.
Figure 2a is a side view of a wafer that is supplied to the wafer processing apparatus.
Figure 2b is a side view of a wafer in a grinding condition.
Figure 2c is a side view of a wafer after grinding.
Figure 2d is a side view of a wafer whereon a die attachment paste film has been formed.
Figure 3 is a schematic diagram of a die attachment paste application unit in the first embodiment of the present invention.
Figure 4 is a schematic diagram of a die attachment paste application unit in the second embodiment of the present invention.
Figure 5a is a first explanatory view of a die attachment paste application unit according to the second embodiment of the present invention.
Figure 5b is a second explanatory view of a die attachment paste application unit, according to the second embodiment of the present invention.
Figure 5c is a third explanatory view of a die attachment paste application unit, according to the second embodiment of the present invention.
Figure 6a is a view showing a first screen used in the second embodiment of the present invention.
Figure 6b is a view showing a second screen used in the second embodiment of the present invention.
Figure 6c is a view showing a wafer that has been screen-printed by means of the screens shown in Figures 6a and 6b.
Figure 7 is a side view of a wafer while it is being diced.
Figure 8 is a sectional side view for explaining laser dicing.

### DETAILED DESCRIPTION OF THE PREFERRED EMBODIMENT

The embodiments of the present invention will be explained below with reference to the attached drawings. In the drawings below, the same reference numerals have been used to designate identical members. The scale of these diagrams has been changed appropriately to facilitate understanding.

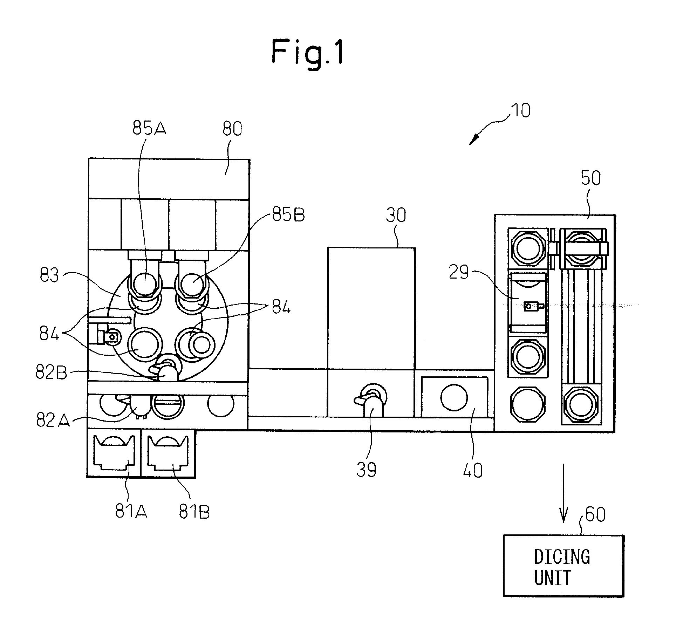

Figure 1 is a schematic plan view of a wafer processing apparatus according to the present invention. The wafer processing apparatus 10 shown in Figure 1 comprises a back-surface grinding unit 80 that grinds the back surface 22 of the wafer 20, a die attachment paste application unit 30 that applies a die attachment paste to the wafer 20, a UV-irradiating unit 40 that irradiates ultraviolet (UV) rays on the die attachment paste, and a dicing tape sticking unit 50 that sticks a dicing tape on the wafer 20. Each of these units is controlled by a controller (not shown).

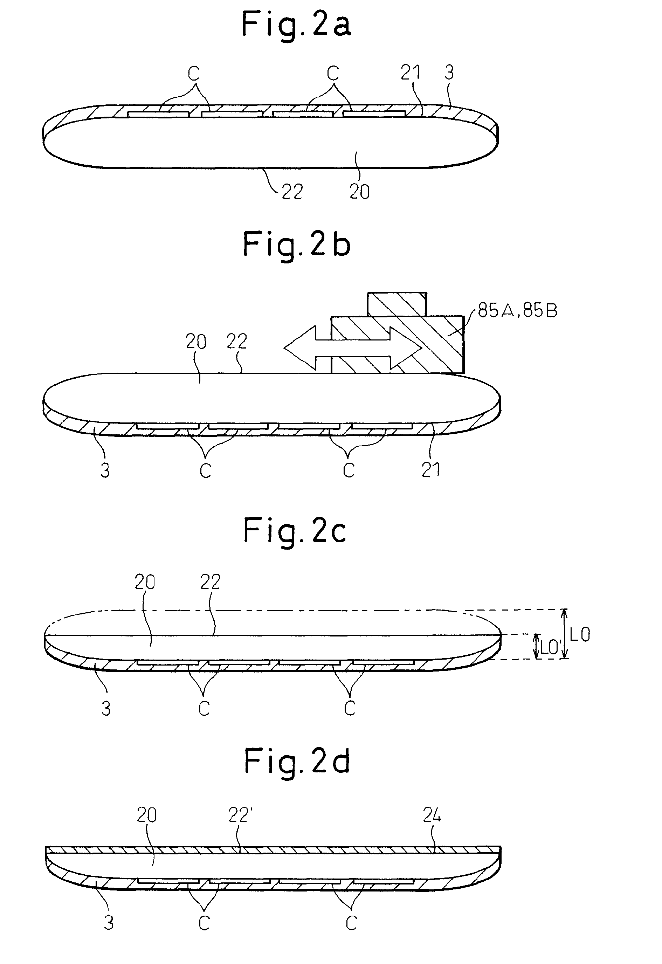

Wafer cassettes 81A and 81B, which store therein a plurality of wafers 20, are provided in the back-surface grinding unit 80. As shown in Figure 2a, a plurality of circuit patterns C are pre-formed on the front surface 21 of the wafer 20 that is supplied to the back-surface grinding unit 80, and a surface protection film 3 is stuck on to the front surface 21 to protect the circuit patterns C.

With reference to Figure 1, each of the wafers 20 are taken out from the wafer cassettes 81A and 81B by robot arms 82A and 82B. Then, the wafer 20 is held, with its back surface 22 facing upward, by suction portions 84 of a rotary stage 83.

As shown in Figure 2b, grinding parts 85A and 85B of the back-surface grinding unit 80 are operated to grind the back surfaces 22 of the wafers 20. As a result of the grinding, as shown in Figure 2c, the thickness of the wafer 20 is reduced from the original wafer thickness LO to the after-grinding thickness LO'.

After completion of the grinding of the wafer 20, the wafer 20 is conveyed by a robot arm 39 from the back-surface grinding unit 80 to the die attachment paste application unit 30. In the die attachment paste application unit 30, a die attachment paste made of an adhesive paste material is applied to the ground back surface 22, so that a die attachment paste film 24 is thereby formed (see Figure 2d.)

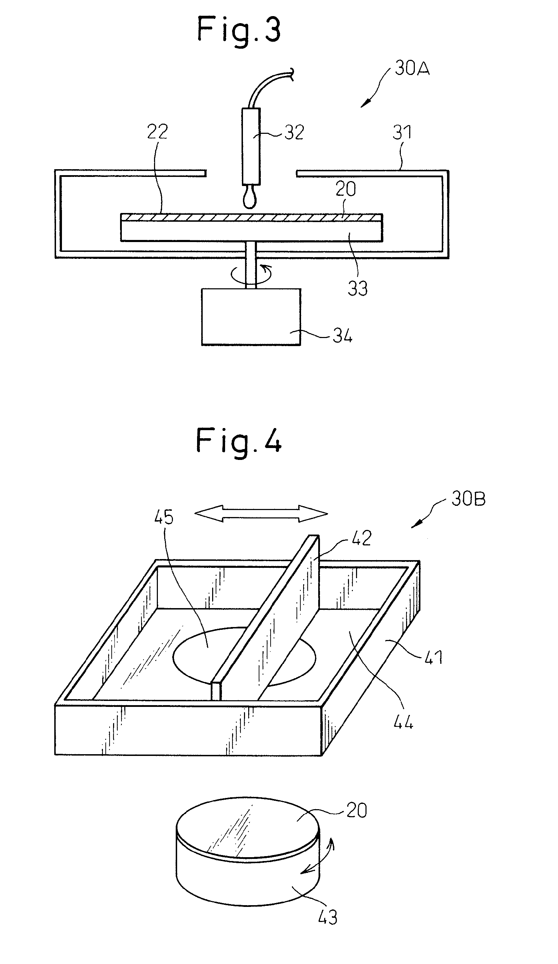

Figure 3 is a schematic diagram of the die attachment paste application unit according to the first embodiment of the present invention. The die attachment paste application unit 30 shown in Figure 3 is a spin-coat type application unit 30A. Note that the surface protection film 3 and the circuit patterns C have been omitted from Figures 3, 4 and 8.

In the embodiment shown in Figure 3, the die attachment paste application unit 30 comprises a holding table 33 that can be rotated by a motor 34, and a dispenser 32 that dispenses die attachment paste.

When the wafer 20 is held on the table 33 with its back surface 22 facing upward, a predefined amount of the die attachment paste is dispensed from the dispenser 32 onto the back surface 22 of the wafer 20. Next, when the table 33 is rotated about its central axis by the motor 34, the die attachment paste is scattered radially by centrifugal force toward the peripheral surface of the housing 31. The die attachment paste film 24 is thereby formed on the back surface 22 of the wafer 20. Then, the die attachment paste film 24 is subjected to a baking treatment.

In this way, when the spin-coat type application unit 30A is used, the die attachment paste can be applied in one operation to the entire back surface 22 of the wafer 20. Consequently, it is possible to apply the die attachment paste in a relatively shorter period of time than compared to a case where it is applied on individual chips after dicing.

As known, the lower the viscosity of the die attachment paste and the greater the rotation speed of the table 33, the smaller the thickness of the die attachment paste film 24. In other words, the thickness of the die attachment paste film 24 can be adjusted by changing the viscosity of the die attachment paste and/or the rotation speed *of the table 33.* Moreover, when the spin-coat type application unit 30A is utilized, the die attachment paste film 24 can be formed at the required thickness, even in cases where the thickness of the die attachment paste required is quite thin. For this reason, the spin-coat type application unit 30A is particularly advantageous in cases where the thickness of the die attachment paste required is quite thin.

Figure 4 is a schematic diagram of the die attachment paste application unit according to the second embodiment of the present invention. The die attachment paste application unit 30 shown in Figure 4 is a screen-printing type application unit 30B.

As shown in Figure 4, the movable squeegee 42 is arranged inside the frame body 41 so as to move along the inner walls of the frame body 41. Moreover, the screen 44 having a hole 45 of a shape corresponding to the wafer 20, is provided on the lower surface of the frame body 41.

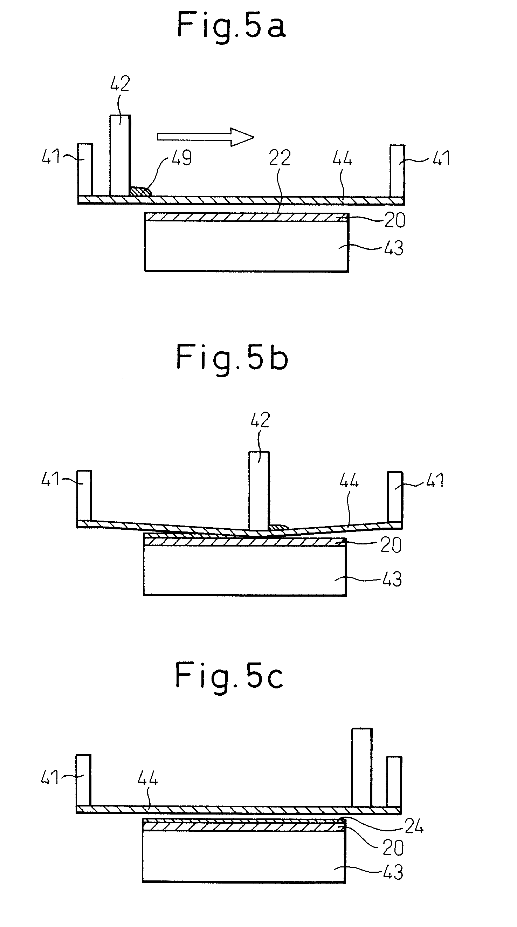

Figures 5a to 5c are views for explaining the die attachment paste application unit according to the second embodiment of the present invention. First, as shown in Figure 5a, with its back surface 22 facing upward, the wafer 20 is held on the table 43, and the squeegee 42 is placed on one side in the frame body 41. Next, a predetermined amount of the die attachment paste 49 is supplied to one side of the squeegee 42, directed to the direction of movement of the squeegee 42.

Next, as shown in Figure 5b, the squeegee 42 is made to move on the screen 44 toward the other side of the frame body 41. As a result of this movement, the die attachment paste flows out from the hole 45 of the screen 44 and is applied little by little on the back surface 22 of the wafer 20. When the squeegee 42 reaches the other side of the frame body 41, the die attachment paste film 24 is formed on the back surface 22 of the wafer 20. It should be evident that also in this embodiment, the die attachment paste can be applied in a relatively shorter period of time than compared to a case where it is applied on individual chips after dicing.

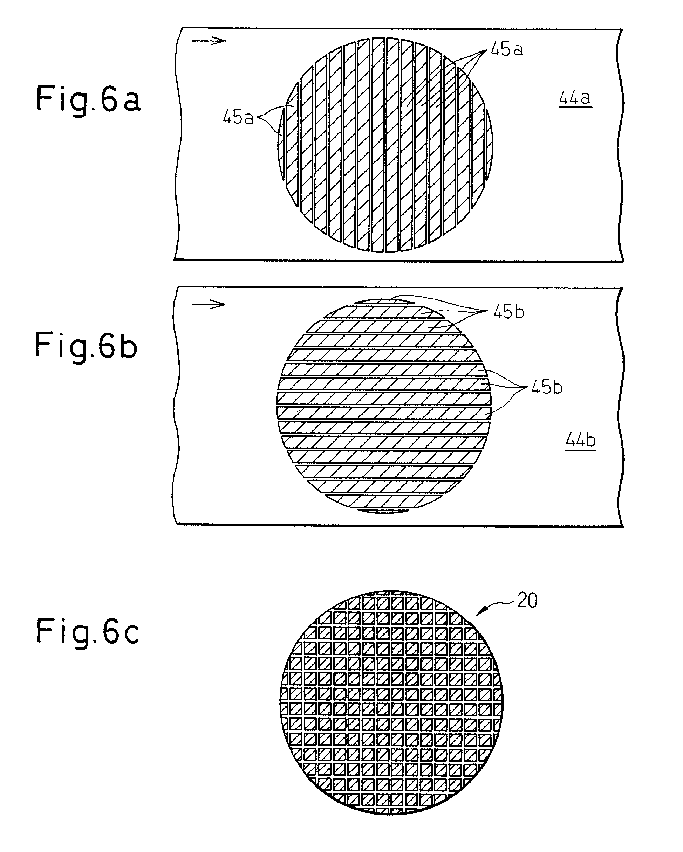

In the second embodiment, it is desirable that the screen-printing process be carried out twice using the first screen 44a and the second screen 44b. Figure 6a and Figure 6b respectively show the first screen and the second screen. Note that the arrows found in these diagrams indicate the direction of movement of the squeegee 42.

As can be seen from these diagrams, a plurality of elongated holes 45a that are substantially parallel to each other and evenly spaced apart are formed in the first screen 44a. These holes 45a are formed so that as a whole they correspond to the external diameter of the wafer 20. A plurality of elongated holes 45b that are perpendicular to the holes 45a of the first screen 44a are formed in the second screen 44b similarly to the way the holes 45a are formed.

The spaces between the plurality of holes 45a shown in Figure 6a and the spaces between the plurality of holes 45b shown in Figure 6b correspond substantially to the spaces between the circuit patterns C formed on the front surface 21 of the wafer 20. Therefore, the spaces between the plurality of holes 45a and the spaces between the plurality of holes 45b respectively correspond to the plurality of channels formed during the dicing process mentioned below.

When these screens 44a and 44b are used, the table 43 is rotated so that the spaces between the circuit patterns C and the spaces between the holes of the first screen 44a are made to coincide, using a near-infrared ray camera (not shown) and a positioning pattern previously formed on the front surface 21 of the wafer 20. The screen-printing process of the first screen 44a is performed under the situation.

Next, the table 43 is rotated approximately 90 degrees, and the spaces between the circuit pattern C and the spaces between the holes of the second screen 44b are made to coincide. After that, the screen-printing process of the second screen 44b is performed. As a result of this printing, as shown in Figure 6c, the die attachment paste is applied to the back surface 22 of the wafer 20, except for the lattice-shaped parts. The lattice-shaped parts correspond to channels that are formed in the dicing process.

With reference to Figure 1, the wafer 20 on which the die attachment paste film 24 has been formed is conveyed to the UV-irradiating unit 40. In the UV-irradiating unit 40, a predefined quantity of UV is irradiated to the die attachment paste film 24. The die attachment paste film 24 thereby assumes the desired adhesion.

Next, the wafer 20 is conveyed to the dicing tape sticking unit 50, and the dicing tape 29 is stuck on the die attachment paste film 24 of the wafer 20 according to a known technique. Next, the surface protection film 3 that is stuck on the top surface 21 of the wafer 20 is peeled off using a known technique, and then the wafer 20 is conveyed to the dicing unit 60 and diced.

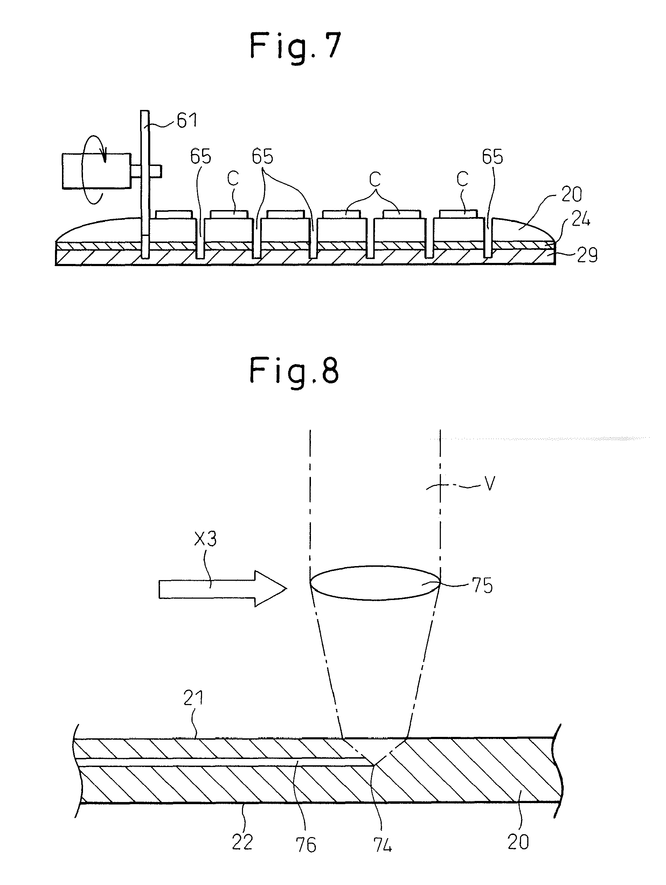

Figure 7 is a side view of the wafer 20 as it is being diced. In the dicing unit 60, the wafer 20 is cut by the part of the dicing tape 29 by the dicing blade 61.

In the second embodiment, the dicing blade 61 cuts the wafer 20 by moving along the lattice-shaped parts (see Figure 6c) on which the die attachment paste film 24 has not been formed. Consequently, the channels 65 formed by the dicing blade 61 correspond substantially to the aforementioned lattice-shaped parts. Due to the foregoing, the dicing blade 61 hardly cuts the die attachment paste film 24. Therefore, in the second embodiment, it is possible to prevent the dicing blade 61 from becoming clogged with the die attachment paste film 24, and the cutting ability of the dicing blade 61 from being reduced.

While the channels (grooves) 65 are formed by the dicing blade 61 according to Figure 7, the channels 65 may be formed in other ways. Moreover, it is also possible to form the channels 65 by means of a laser dicing device.

Figure 8 is a sectional side view for explaining laser dicing. In Figure 8, the laser V from a laser source (not shown) is irradiated through a condensing lens 75 onto the front surface 21 of the wafer 20 under conditions where multiple photon absorption occurs. At this point, the light gathering point 74 is set to fall inside the wafer 20 rather close to the front surface 21. A modified area 74 is thereby formed in the vicinity of the light gathering point 74. Next, when the laser V and the condensing lens 75 are moved in accordance with the arrow X3, a band-like modified area 76 is formed inside the wafer 20.

In the laser dicing process, the laser V is made to pass through the wafer 20 and cause multiple photon absorption to occur inside the wafer. A modified area is thus formed. Consequently, the laser V is hardly absorbed by the front surface 21 of the wafer 20, and as a result, the front surface 21 of the wafer 20 does not melt, and cracks that deviate from the lines planned to be cut or the like do not occur on the top surface of the wafer.

As the modified area 76 is formed rather close to the front surface 21, when the modified area 76 breaks naturally in the thickness direction toward the front surface 21, the channels 65 corresponding to the width of the laser V are formed. As mentioned above, when the die attachment paste is applied, except for the lattice-shaped parts, there is no need to cut off the die attachment paste layer before or after the dicing, and consequently a laser dicing system can be utilized in the dicing unit 60.

The wafer 20 is diced and divided into individual chips by the dicing operation shown in Figure 7 or Figure 8. Next, the dicing tape 29 is expanded by means of a known technique, and, each chip is picked up from the dicing tape 29. The die attachment paste films 24, which serve as an adhesive on the bottom surfaces of the chips, the chips can then be die-bonded on to a lead frame or the like.

In this way, according to the present invention, the die attachment paste application unit 30 is arranged between the back-surface grinding unit 80 for the wafer 20 and the dicing unit 60. The invention provides for the die attachment paste to be applied in one operation on the entire ground back surface 22 of the wafer 20 in the die attachment paste application unit 30. For this reason, it is possible to apply die attachment paste in a shorter period of time than compared to a case where die attachment paste is separately applied to the individual chips after dicing.

Note that in the die attachment paste application unit 30, die attachment paste may be applied on the back surface 22 of the wafer 20 using a technique other than spin-coating or screen-printing, such as a so-called inkjet method. It should be understood that such cases also fall within the scope of the present invention.

The present invention has been explained using representative embodiments, however it should be understood that a person skilled in the relevant art could execute the abovementioned change and various other modifications, omissions or additions, without deviating from the scope of the present invention.

## Claims

1. A wafer processing method comprising:
a grinding step for grinding a back surface of a wafer having on its front surface a circuit pattern, and
a die attachment paste application step for applying a die attachment paste on the entirety of the ground back surface of said wafer.

2. The wafer processing method of Claim 1, further comprising:
a sticking step for sticking a dicing tape on the applied die attachment paste, and
a dicing step for dicing the wafer according to the circuit pattern.

3. The wafer processing method of Claim 1 or 2, wherein the die attachment paste supplied on the back surface of the wafer is spin-coated in the die attachment paste application step.

4. The wafer processing method of Claim 1 or 2, wherein the die attachment paste is screen-printed on to the back surface of the wafer in the die attachment paste application step.

5. The wafer processing method of Claim 4, wherein the die attachment paste is applied in the screen-printing step, except on the portions corresponding to channels formed when the wafer is diced.

6. A wafer processing apparatus comprising:
a grinding means for grinding a back surface of a wafer having on its front surface a circuit pattern, and
a die attachment paste application means for applying a die attachment paste on the entire back surface of the wafer ground by said grinding means.

7. The wafer processing apparatus of Claim 6, further comprising:
a dicing tape sticking means for sticking a dicing tape on the die attachment paste applied by the die attachment paste application means, and
a dicing means for dicing the wafer according to the circuit pattern.

8. The wafer processing apparatus of Claim 6 or 7, wherein the die attachment paste application means comprises a spin-coating means for spin-coating the die attachment paste supplied on the back surface of the wafer.

9. The wafer processing apparatus of Claim 6 or 7, wherein the die attachment paste application means comprises a screen-printing means for screen-printing the die attachment paste on the back surface of the wafer.

10. The wafer processing apparatus of Claim 9, wherein the screen-printing means applies the die attachment paste, except on the portions corresponding to the channels formed when the wafer is diced.
